**Europäisches Patentamt**

(19) **European Patent Office**

**Office européen des brevets**

(11) Publication number : **0 437 214 B1**

## (12) EUROPEAN PATENT SPECIFICATION

(45) Date of publication of patent specification :
07.06.95 Bulletin 95/23

(51) Int. Cl.$^6$ : **G01R 31/02**, G01R 31/12

(21) Application number : **91100103.0**

(22) Date of filing : **02.01.91**

(54) Method for diagnosing an insulation deterioration of an electric apparatus.

(30) Priority : **09.01.90 JP 2186/90**

(43) Date of publication of application :
**17.07.91 Bulletin 91/29**

(45) Publication of the grant of the patent :
**07.06.95 Bulletin 95/23**

(84) Designated Contracting States :
**DE FR GB SE**

(56) References cited :
**IEEE TRANSACTIONS ON POWER DELIVERY.
vol. 4, no. 2, April 1989, NEW YORK USpages
857 - 862; A. NAKAJIMA ET AL.: 'DEVELOP-
MENT OF A HOT-LINE DIAGNOSTICMETHOD
FOR XLPE CABLES AND MEASUREMENT RE-
SULTS'**

(56) References cited :
**IEEE TRANSACTIONS ON POWER DELIVERY.
vol. 2, no. 1, January 1987, NEW YORK
USpages 1 - 7; H. OONISHI ET AL.: 'DEVELOP-
MENT OF A NEW DIAGNOSTIC METHOD
FORHOT-LINE XLPE CABLES WITH WATER
TREES'
PATENT ABSTRACTS OF JAPAN vol. 9, no. 68
(P-344)(1791) 28 March 1985**

(73) Proprietor : **HITACHI CABLE, LTD.**
**1-2, Marunouchi 2-chome**
**Chiyoda-ku Tokyo 100 (JP)**

(72) Inventor : **Soma, Kenichiro**
**21 Kamikotsuta,**
**Hanakawamachi**
**Kitaibaraki-shi, Ibaraki (JP)**
Inventor : **Kotani, Kazuo**
**5-104, Hitakacho 4-24**
**Hitachi-shi, Ibaraki (JP)**
Inventor : **Takaoka, Nobuju**
**13-302, Hitakacho 3-15**
**Hitachi-shi, Ibaraki (JP)**

(74) Representative : **Goddar, Heinz J., Dr. et al**
**FORRESTER & BOEHMERT**
**Franz-Joseph-Strasse 38**
**D-80801 München (DE)**

EP 0 437 214 B1

## Description

### FIELD OF THE INVENTION

The invention relates to a method for diagnosing an insulation deterioration of an electric apparatus, and more particularly to a method for diagnosing an insulation deterioration of a power cable such as a cross-linked polyethylene insulated cable, in which an insulation deterioration of the cable is detected under a state that a rated line voltage is applied to a power cable system, with the features of the preamble of claim 1 as known from IEEE Transaction on Power Delivery, vol.4, no.2, April 1989, page 857-862.

### BACKGROUND OF THE INVENTION

It has been clarified in the art that an insulation deterioration of a power cable such as a cross-linked polyethylene insulated cable (hereinafter defined CV cable) is mainly caused by the absorption of moisture into the solid insulation material to which a rated line voltage is applied. In the circumstance, water tree is induced in the insulation material, and is then developed therein to finally result in a breakdown of the power cable. Therefore, a method for detecting the insulation deterioration including water tree is required to be established, thereby avoiding the breakdown of an insulation material for a power cable in advance.

A first type of a conventional method for diagnosing an insulation deterioration of a power cable comprises a step of measuring an insulation resistance of the power cable by use of a megger.

In this method, however, there is a disadvantage in that a cable having an insulation deterioration immediately causing the breakdown can not be detected. Therefore, this method is not a sufficiently satisfactory method for diagnosing an insulation deterioration of a power cable.

A second type of a conventional method for diagnosing an insulation deterioration of a power cable, comprises steps of applying a direct current (DC) high voltage to an insulation of the power cable, and detecting leakage direct current flowing through the insulation, so that the insulation deterioration is diagnosed dependent on a level of the leakage direct current.

In this method, however, there is a disadvantage in that a power cable to which a rated load voltage is applied to supply electric power to actual loads is not diagnosed. Even worse, there is a further disadvantage in that the insulation deterioration is badly promoted to result in the breakdown of the power cable in some case dependent on a degree of the insulation deterioration, because the diagnosing DC high voltage is applied to the power cable.

In view of these situations, another method of diagnosing an insulation deterioration of a power cable has been proposed to detect water trees generated in a deteriorated insulation of a 6 kV power distribution CV cable. This method which is similar to the method disclosed in the IEEE document comprises steps of detecting a direct current component of a minute level included in a charging current of the CV cable in a state that a 6 kV power distribution voltage is applied to the CV cable to supply electric power to loads of a power distribution system, and diagnosing whether an insulation deterioration has occured in the insulation by checking value and waveform of the direct current component. The detection of the direct current component is carried out by use of a ground wire of the CV cable, through which the direct current component flows.

However, this proposed method is not applied to a CV cable power distribution system having a line voltage of more than 22 kV, because the CV cable is connected to ground at multi-points. Even if the CV cable is not connected to ground at the multi-points, the detection of the direct current component is very hard at an installation site of the CV cable.

### SUMMARY OF THE INVENTION

Accordingly, it is an object of this invention to provide a method for diagnosing an insulation deterioration of an electric apparatus, especially, a CV cable for more than 22 kV, in which the insulation deterioration caused by water trees is precisely detected.

According to this invention, a method for diagnosing an insulation deterioration of an electric apparatus, comprises steps of claim 1. Preferred embodiments of the invention are subject watter of claims 2 to 4.

A polarity and a level of the DC voltage to be biased to the AC voltage is determined by a polarity and a level of the direct current component flowing through the insulation only by applying the AC voltage. Consequently, no breakdown of the insulation occurs during the diagnosis procedure of the insulation deterioration. This invention is advantageously applied to the diagnosis of an insulation deterioration for a CV cable for more than 22 kV. In this application, an AC voltage is applied across a conductor and a metal shield which is connected to ground to detect a direct current component flowing through a cross-linked polyethylene insulation.

BRIEF DESCRIPTION OF THE DRAWINGS

This invention will be explained in more detail in conjunction with appended drawings, wherein:

Fig. 1 is a circuitry diagram showing a method for diagnosing an insulation deterioration of a CV power cable in a preferred embodiment according to the invention;

Figs. 2A and 2B are graphs explaining a relation between an amplified direct current component and a bias DC voltage; and

Fig. 3 is an explanatory diagram illustrating the method of the preferred embodiment applied to a CV cable system.

DESCRIPTION OF THE PREFERRED EMBODIMENTS

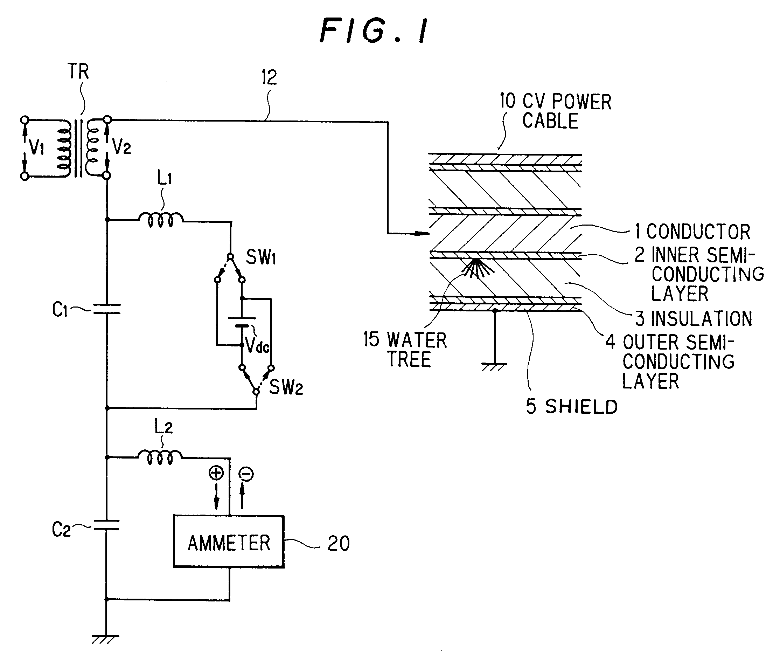

Fig. 1 explaines a method for diagnosing an insulation deterioration of a CV cable 10 having a water tree 15 in a cross-linked polyethylene insulation 3 according to the invention. A circuit for detecting a direct current component flowing through the insulation 3 comprises a transformer TR for applying an AC voltage $V_2$ which is obtained from an AC voltage $V_1$ through a lead 12 to a conductor 1 of the CV cable 10, capacitances $C_1$ and $C_2$ provided between a secondary winding of the transformer TR and ground, a DC voltage biasing circuit including a blocking coil $L_1$, a DC power supply Vdc, and switches $SW_1$ and $SW_2$ for changing the polarity of a bias DC voltage, and a direct current component detecting circuit including a blocking coil $L_2$ and an ammeter 20. The CV cable 10 comprises a conductor 1, an inner semiconductive layer 2 provided on the conductor 1, the cross-linked polyethylene insulation 3, an outer semiconducting layer 4 provided on the insulation 3, and a metal shield 5 connected to ground. A polyvinylchloride anti-corrosion layer provided on the metal shield 5 is not shown in Fig. 1. Here, it is assumed that a polarity of a direct current component is positive, when the direct current component flows from the metal shield 5 to the conductor 1. The polarity is shown in Fig. 1 by the symbols $\oplus$ and $\ominus$.

In operation, an AC voltage obtained at secondary terminals of the transformer TR is applied across the conductor 1 and the metal shield 5, so that a charging current flows through the insulation 3. A direct current component which is included in the charging current is detected by the ammeter 20.

If the polarity of the direct current component is positive, the switches $SW_1$ and $SW_2$ are turned on, as shown by dotted lines. Thus, the positive direct current is amplified, and is detected by the ammeter 20.

On the other hand, if the polarity of the direct current component is negative, the switches $SW_1$, and $SW_2$ are turned on, as shown by solid lines. Thus, the negative direct current component is amplified, and is detected by the ammeter 20.

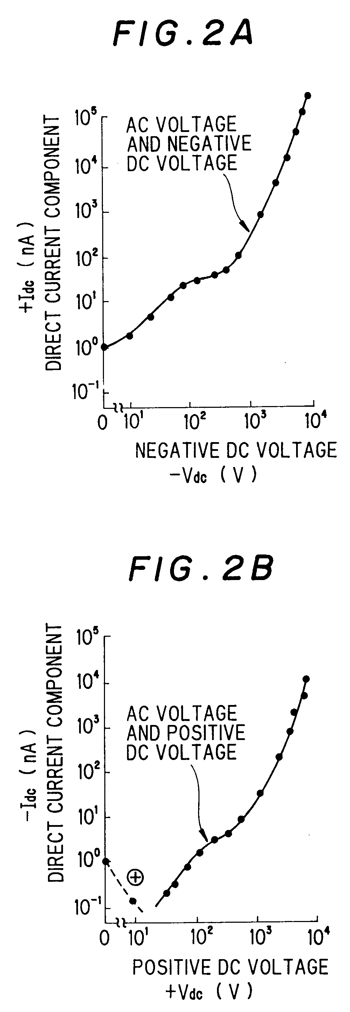

Fig. 2A shows an amplified direct current component Idc, when a negative bias voltage -Vdc is applied to the conductor 1, that is, the switchs $SW_1$ and $SW_2$ are turned on as shown by the dotted lines in Figure 1. The direct current component Idc increases with a relatively complicated motion, as the negative bias voltage -Vdc increases in its absolute value. When the negative bias voltage -Vdc is -1000V, the direct current component Idc is amplified by two to three orders of magnitude, as compared to a direct current component flowing through the insulation 3 only by the application of an AC voltage.

Fig. 2B shows an amplified direct current component -Idc, when a positive bias voltage Vdc is applied to the conductor 1, that is, the switches $SW_1$ and $SW_2$ are turned on as shown by the solid lines in Figure 1. At first, the positive direct current component $\oplus$ decreases, as the positive bias voltage Vdc increases from zero to approximately $10^1$ V, and the positive direct current component $\oplus$ becomes zero at a positive bias voltage +Vdc. Then, a negative direct current component -Idc begins to flow through the insulation 3, as the positive bias voltage Vdc further increases, and the negative direct current component -Idc increases in its absolute value in proportional to the increase of the positive bias voltage Vdc.

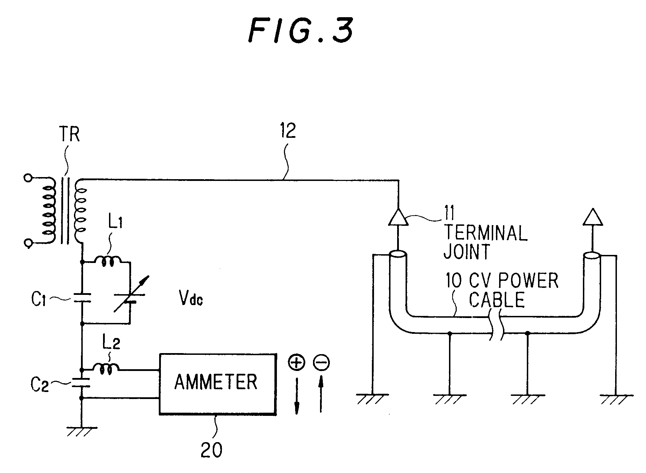

Fig. 3 explaines a method for diagnosing an insulation deterioration of a CV cable 10 which is connected at multi-points to ground. In this method, a conductor of the CV cable 10 is connected through a lead 12 to a transformer TR by a terminal joint 11. The transformer TR is connected through serial capacitances $C_1$ and $C_2$ to ground, and a DC bias voltage applying circuit including a blocking coil $L_1$ and a DC power supply Vdc and a direct current component detecting circuit including, a choke coil $L_2$ and an ammeter 20 are connected in parallel to the capacitances $C_1$ and $C_2$, respectively.

The detection of a direct current component and an amplified direct current component is carried out on the CV cable 10 which has been installed at an installation site in the same manner as in Fig. 1. Then, the CV cable is removed from the installation site, and is subject to an AC voltage breakdown test. The length of water trees found in an insulation of the removed CV cable is measured. The results are shown in TABLE 1.

TABLE 1

| SAMPLE | | AT INSTALLATION SITE | | | | | REMOVED | |
|---|---|---|---|---|---|---|---|---|
| | | APPLYING AC VOLTAGE WITHOUT DC BIAS VOLTAGE | | APPLYING AC VOLTAGE WITH DC BIAS VOLTAGE | | INSULATION RESISTANCE BY 1000V-MEGGER | AC BREAKDOWN VOLTAGE | WATER TREE LENGTH |
| NO. | PHASE | AC VOLTAGE | DC COMPONENT | DC BIAS VOLTAGE | AMPLIFIED DC COMPONENT | | | |
| 1 | RED | 12.7kV | +0.1nA> | -1kV | +0.1nA> | 2000MΩ< | 80kV | NOT MEASURED |
| | WHITE | 12.7kV | +0.1nA> | -1kV | +0.1nA> | 2000MΩ< | 90kV | NOT MEASURED |
| | BLUE | 12.7kV | +0.4nA | -1kV | +33nA | 2000MΩ< | 50kV | 4.5mm |
| 2 | RED | 12.7kV | -0.1nA> | +1kV | -0.1nA> | 2000MΩ< | 110kV | NOT MEASURED |
| | WHITE | 12.7kV | -0.1nA> | +1kV | -0.1nA> | 2000MΩ< | 100kV | NOT MEASURED |
| | BLUE | 12.7kV | -3nA | +1kV | -2500nA | 2000MΩ< | 40kV | 5.3mm |
| 3 | RED | 12.7kV | -1300nA | +0.1kV | -73000nA | 110MΩ | 25kV | 6.3mm |
| | WHITE | 12.7kV | +0.1nA> | -1kV | +0.1nA> | 2000MΩ< | 70kV | 0.5mm |
| | BLUE | 12.7kV | +0.1nA> | -1kV | +0.1nA> | 2000MΩ< | 75kV | 0.5mm |
| 4 | RED | 12.7kV | +0.1nA> | -1kV | +0.1nA> | 2000MΩ< | 90kV | NOT MEASURED |
| | WHITE | 12.7kV | -24nA | +0.5kV | -19000nA | 200MΩ | 35kV | 5.9mm |
| | BLUE | 12.7kV | +0.1nA> | -1kV | +0.1nA> | 2000MΩ< | 80kV | NOT MEASURED |

As understood from TABLE 1, when a direct current component of more than 0.4nA flows through the insulation of the CV cable 10, in a state that an AC voltage of 12.7 kV is applied to the CV cable 10 by the transformer TR a predetermined length of water tree is found in the insulation of the CV cable 10. The length of water tree is proportional to an absolute value of an amplified direct component, and an AC breakdown voltage is lowered proportionally to the absolute value. When the AC breakdown voltage is more than 80 kV, no water tree is found in an aperture of breakdown.

Accordingly, a CV cable having an insulation deteriorated by water tree can be precisely detected by measuring a direct current component flowing at the time of an AC voltage application and an amplified direct current component flowing at the time of an AC voltage and DC bias voltage applications.

This invention is not only applied to a CV cable, but other cables such as an oil filled (OF) cable, a rubber insulated cable, etc., a normal joint, a terminal joint, etc. of power cable, and electric machines such as a transformer, an electric motor, an arrester, etc.

Thus, the breakdown of an insulation of such electric machines is avoided, so that an electric machine having an insulation deteriorated by water tree is replaced in advance of the breakdown by a new one. Accordingly, the stop of electric power service causing a serious problem is precisely avoided.

## Claims

1. A method for determination of an insulation deterioration of an electric apparatus (10) due to a water tree in the insulation (3) of said electric apparatus by detecting a direct current component included in a charging current flowing through said insulation (3) when an AC voltage is applied thereto;
   applying an AC voltage across two conductive members (1, 5) insulated by said insulation (3) to detect a first direct current component flowing through said insulation (3);
   applying a DC bias voltage to said AC voltage;
   measuring the level of a second direct current component through said insulation (3) when said AC voltage and said DC bias voltage are applied, thereby detecting an insulation deterioration from the absolute value of said level,
   detecting the polarity of a direct current component under said applying of said AC voltage;
   said method being characterized in that
   the polarity of said first direct current component is detected,
   the polarity of said DC bias voltage to be applied is determined by said polarity of said first direct current component in such a way that said second direct component has the same polarity as said first direct current component and a level whose absolute value exceeds the absolute value of the level of said first direct current component.

2. A method according to claim 1, wherein:
   said electric apparatus (10) is a power cable, a transformer, a electric motor, a high voltage switch or an arrester.

3. A method according to claim 2, wherein:
   said power cable is a cross-linked polyethylene insulated cable; and said two members (1, 5) are a conductor and a metal shielding layer of said cross-linked polyethylene insulated cable.

4. A method according to claim 1, wherein:
   the level of said first direct current component is measured and the level of said DC bias voltage is determined by the level of said first direct current component.

## Patentansprüche

1. Ein Verfahren zum Bestimmen der Verschlechterung der Isolation eines elektrischen Gerätes (10) aufgrund eines in der Isolation (3) des elektrischen Gerätes auftretenden Wasserbaumes durch Erkennen einer Gleichstromkomponente, die in einem Ladestrom, der durch Isolation (3) fließt, wenn eine Wechselstromspannung auf diesen aufgebracht wird, fließt;
   Aufbringen einer Wechselstromspannung über zwei leitende Elemente (1, 5), die durch die Isolation (3) isoliert sind, um eine erste Gleichstromkomponente, die durch die Isolation (3) fließt, zu erkennen;
   Aufbringen einer Gleichstrom-Vorspannung auf die Wechselstromspannung;

Messen der Höhe einer zweiten Gleichstromkomponente durch die Isolation (3), wenn die Wechselstromspannung und die Gleichstromvorspannung aufgebracht werden, um so eine Verschlechterung der Isolation aus dem Absolutwert der Höhe zu ermitteln,

Erkennen der Polarität einer Gleichstromkomponente während der Aufbringes der Wechselstromspannung;

wobei das Verfahren dadurch gekennzeichnet ist, daß die Polarität der ersten Gleichstromkomponente erkannt wird, und

die Polarität der Gleichstromvorspannung, die aufgebracht werden soll, durch die Polarität der ersten Gleichstromkomponente derart bestimmt wird, daß die zweite Gleichstromkomponente dieselbe Polarität wie die erste Gleichstromkomponente hat und eine Höhe, deren Absolutwert den Absolutwert der Höhe der ersten Gleichstromkomponente übersteigt.

2. Ein Verfahren nach Anspruch 1, wobei:
das elektrische Gerät (10) ein Leistungskabel, ein Transformator, ein Elektromotor, ein Hochspannungsschalter oder eine Blitzschutzeinrichtung ist.

3. Ein Verfahren nach Anspruch 2, wobei:
das Leistungskabel ein mit Mischpolyethylen isoliertes Kabel ist und die beiden Elemente (1, 5) ein Leiter und eine metallische Abschirmschicht des durch das Mischpolyethylen isolierte Kabel sind.

4. Ein Verfahren nach Anspruch 1, wobei:
die Höhe der ersten Gleichstromkomponente gemessen wird und die Höhe der Gleichstrom-Vorspannung anhand der Höhe der ersten Gleichstromkomponente bestimmt wird.

**Revendications**

1. Procédé pour déterminer une détérioration de l'isolation d'un appareillage électrique (10) due à une propagation arborescente d'eau dans l'isolation (3) dudit appareillage électrique, en détectant une composante de courant continu incluse dans un courant de charge passant dans ladite isolation (3), lorsqu'une tension de courant alternatif lui est appliquée ;

en appliquant une tension alternative sur deux organes conducteurs (1, 5) isolés par ladite isolation (3), pour détecter une première composante de courant continu passant dans ladite isolation (3) ;

en appliquant une tension de polarisation de courant continu à ladite tension de courant alternatif ;

en mesurant le niveau d'une deuxième composante de courant continu passant dans ladite isolation (3) lorsque ladite tension de courant alternatif et ladite tension de polarisation de courant continu sont appliquées de manière à détecter une détérioration de l'isolation par rapport à la valeur absolue dudit niveau ;

en mesurant la polarité d'une composante de courant continu lors de ladite application de ladite tension de courant alternatif ;

ledit procédé étant caractérisé en ce que

la polarité de la première composante de courant continu est détectée, la polarité de ladite tension de polarisation de courant continu à appliquer est déterminée par ladite polarité de ladite première composante de courant continu, de manière que ladite deuxième composante de courant continu ait la même polarité que ladite première composante de courant continu et un niveau dont la valeur absolue dépasse la valeur absolue du niveau de ladite première composante de courant continu.

2. Procédé selon la revendication 1, dans lequel :
ledit appareillage électrique (10) est un câble d'alimentation, un transformateur, un moteur électrique, un commutateur à haute tension ou un dispositif d'arrêt.

3. Procédé selon la revendication 2, dans lequel :
ledit câble d'alimentation est un câble isolé en polyéthylène réticulé ; et lesdits deux organes (1, 5) sont un conducteur et une couche de protection métallique dudit câble isolé en polyéthylène réticulé.

4. Procédé selon la revendication 1, dans lequel :
le niveau de ladite première composante de courant continu est mesuré et le niveau de ladite tension de polarisation de courant continu est déterminé par le niveau de ladite première composante de courant continu.

FIG. 1

EP 0 437 214 B1

## FIG. 2A

## FIG. 2B

# FIG.3